# EUROPEAN PATENT SPECIFICATION

(11) **EP 3 070 738 B1**
(45) Date of publication and mention of the grant of the patent: **07.11.2018**
(21) Application number: 14861471.2
(22) Date of filing: 10.11.2014
(51) Int. Cl.: H01L 23/12, B81B 7/00, B81C 1/00, H01L 23/14

(54) **THROUGH ELECTRODE AND METHOD FOR PRODUCING MULTILAYER SUBSTRATE USING THROUGH ELECTRODE**
DURCHGANGSELEKTRODE UND VERFAHREN ZUR HERSTELLUNG EINES MEHRSCHICHTIGEN SUBSTRATS MITTELS DER DURCHGANGSELEKTRODE
ÉLECTRODE DÉBOUCHANTE ET PROCÉDÉ POUR PRODUIRE UN SUBSTRAT MULTICOUCHE EN UTILISANT L'ÉLECTRODE DÉBOUCHANTE

(30) Priority: 13.11.2013 JP 2013234562
(43) Date of publication of application: 21.09.2016
(73) Proprietor: Tanaka Kikinzoku Kogyo K.K., Chiyoda-ku Tokyo 100-6422 (JP)
(72) Inventor: OGASHIWA, Toshinori, Hiratsuka-shi Kanagawa 254-0076 (JP); MURAI, Hiroshi, Hiratsuka-shi Kanagawa 254-0076 (JP); KANEHIRA, Yukio, Hiratsuka-shi Kanagawa 254-0076 (JP)
(74) Representative: Boult Wade Tennant LLP
(86) International application number: PCT/JP2014/079710
(87) International publication number: WO 2015/072422

(56) References cited:
- JP-A- H06 350 376
- JP-A- 2001 102 756
- JP-A- 2009 152 496
- JP-A- 2011 071 153
- JP-A- 2013 206 765

## Description

### Technical Field

The present invention relates to a through electrode to be applied to a circuit board for electrical and electronic devices. It specifically relates to a through electrode having a sealing function for suppressing leakage from the through electrode section.

### Background Art

As a method for mounting a semiconductor device or the like on a circuit board for use in various electrical and electronic devices, a method in which a through electrode is formed on a multilayered circuit board, and an element is mounted on such a circuit board, is sometimes employed. Such a mounting process is useful to provide a circuit board with higher performance and higher density at the same time, and is highly likely to continue to be frequently used.

As a means for forming such a through electrode, the Applicant has developed a method in which a through hole is filled with a metal paste containing a metal powder having a predetermined particle size/purity and an organic solvent, followed by sintering, and the resulting sintered body is used as an electrode. This sintered body is formed when the fine metal powder is firmly bound while undergoing plastic deformation. Such a sintered body is relatively dense and can act as an electrode. Additionally, in the Applicant's through electrode, a glass-frit-free metal paste, which is different from common metal pastes for electrode formation, is used. Thus, organic matters that serve as impurities are not present in the electrode, and its electrical characteristics are also excellent.

### Related Art Document

### Patent Document

Patent Document 1: JP 2005-109515 A

Patent Document JP 2009-152496 discloses a through electrode for being mounted on a substrate having a through hole, comprising:a penetrating part passing through the through hole; a convex bump part formed on at least one end of the penetrating part and wider than the penetrating part; and a metal film having at least one layer and formed on a surface of the convex bump part coming in contact with the substrate, wherein the penetrating part and the convex bump part are formed of a sintered body prepared by sintering one or more kind of metal powder selected from gold, silver, palladium, and platinum.

### Summary of the Invention

### Problems to be Solved by the Invention

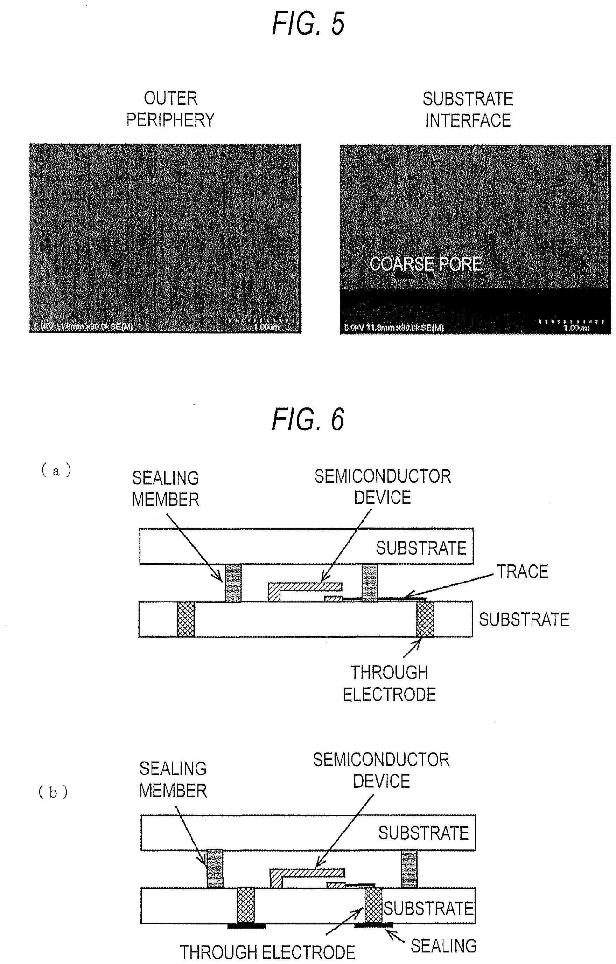

Many elements to be mounted on a substrate, including various sensor elements (MEMS element, and the like), require a sealing treatment for shielding the element from the outdoor air after mounting. For the production of a circuit board including such an element, it is necessary to seal around the element with a suitable sealing member, and pass a trace through the sealing member to connect the element and a through electrode (Fig. 6(a)). However, when the trace length increases, due to its resistance, the transmission of high-frequency signals may be affected, whereby the element performance is not sufficiently exerted.

As a measure for reducing the trace length, it is effective to reduce the distance between the through electrode and the element and form the through electrode within the sealed region (Fig. 6(b)). However, in this case, to prevent leakage, the through electrode has to be subjected to a sealing treatment later. The Applicant's through electrode formed of a sintered body described above is dense, but it is not completely a bulk body and may involve coarse pores in some cases. Therefore, hermetic sealing may be broken through the through electrode, and thus the surface of the through electrode has to be subjected to a sealing treatment, such as plating. Such a sealing treatment after electrode formation complicates the circuit board production process, and also leads to a cost increase.

Thus, the present invention provides a through electrode useful for a circuit board having a multilayer structure, which makes it possible to reduce the element trace length and is also adapted to hermetic sealing. Also disclosed is a method of mounting a circuit board to which the through electrode is applied.

### Means for Solving the Problems

The present inventors conducted extensive research to solve the problems, starting with the examination of the characteristics of the Applicant's through electrode formed of a sintered body. According to the examination, depending on the purity and particle size of the metal powder applied, density of the Applicant's through electrode formed of a sintered body is further improved when pressurized, even after the through electrode has become a sintered body. This density improvement by pressurization is caused by, in addition to physical changes such as the plastic deformation/binding of metal particles (powder), changes in the metal structure resulting from recrystallization due to the thermal energy applied by pressurization and heating. It can be said that the portion formed by recrystallization exerts high hermeticity just like a bulk body.

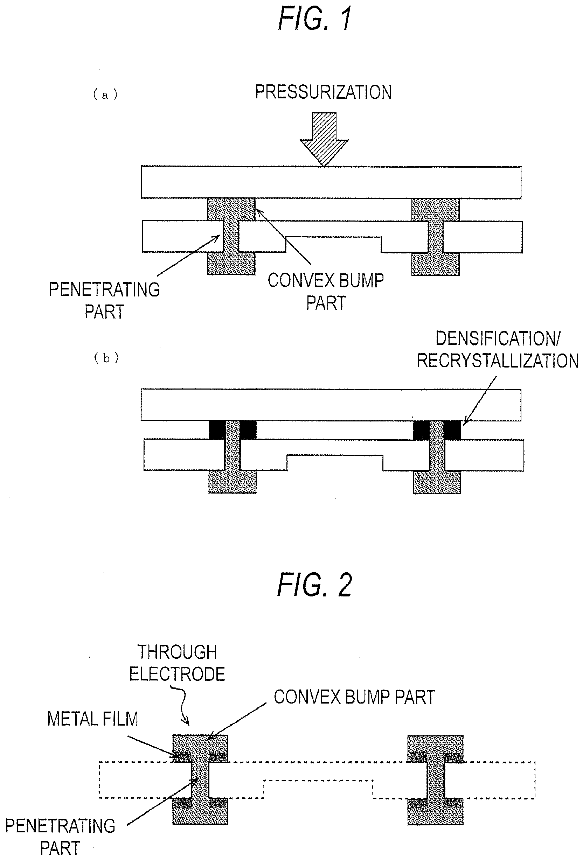

Thus, the present inventors conceived of integrally forming, on an end of the through electrode formed of a sintered body, a bump that is wider than the through electrode formed of a similar sintered body and has a convex shape relative to the substrate surface (Fig. 1(a)). When a through electrode having such a convex bump is formed on a substrate, and the top substrate is pressurized after elements and traces are mounted thereon, it is expected that the peripheral part of the convex bump constrained in the vertical direction undergoes densification due to pressurization (Fig. 1(b)). Thus, it is expected that such a portion acts as a sealing member, and leakage from the through electrode can be suppressed.

For a through electrode provided with a convex bump, the present inventors examined its structure after the compressive deformation and found that although the outer periphery of the convex bump is densified, there are relatively large pores at the contact surface between the convex bump and the substrate. When such coarse pores remain therein, the reliability as a sealing member is lost.

It appears that the formation of coarse pores at the surface of the convex bump in contact with the substrate is attributable to the insufficient binding/recrystallization of the metal powder. Examining this factor, the present inventors surmised that this is attributable to the insufficient adhesion between the convex bump and the substrate.

Thus, for a convex bump provided on an end of a through electrode, the present inventors conceived of forming a predetermined metal film on a surface of the convex bump that comes in contact with the substrate (Fig. 2). With the formation of such a metal film, high-level adhesion occurs due to thermal diffusion at the joining interface between the sintered body and the metal film, whereby recrystallization is promoted. Additionally, with pressurization, the metal film, which is in bulk state, can sufficiently adhere to the substrate and exert a sealing effect. Because of these effects together with the densification of the outer peripheral part of the convex bump described above, the convex bump is allowed to act as a sealing member.

Namely, the present invention provides a through electrode for being mounted on a substrate having a through hole, including: a penetrating part that passes through the through hole; a convex bump part that is formed on at least one end of the penetrating part and is wider than the penetrating part, and a metal film that has at least one layer and is formed on a surface of the convex bump part that comes in contact with the substrate, wherein the penetrating part and the convex bump part are formed of a sintered body prepared by sintering one or more kind of metal powder selected from gold, silver, palladium, and platinum having a purity of 99.9 wt% or more and an average particle size of 0.005 µm to 1.0 µm, and the metal film contains gold, silver, palladium, or platinum having a purity of 99.9 wt% or more.

Hereinafter, the present invention will be described in detail. The penetrating part, which forms the through electrode according to the present invention, is a main constituent of the through electrode for ensuring electrical conductivity between substrates in a multilayer substrate. The size of the penetrating part is suitably determined according to the diameter and length (depth) of a through hole formed in the substrate and thus is not particularly limited.

On one or both ends of the penetrating part, a convex bump part wider than the penetrating part is provided. As described above, the convex bump part is pressurized during the joining of the multilayer substrate and undergoes recrystallization at the periphery thereof to act as a sealing member to suppress leakage from the through electrode. Additionally, the convex bump part is electrically connected to an element on the substrate, and thus plays the role of ensuring electrical connection between substrates of the multilayer substrate through the through electrode.

It is required that the dimension of the convex bump part in the transverse direction is wider than the penetrating part. The dimension is preferably 1.5 to 10 times the width (diameter) of the through electrode. When the width is too small, the resulting recrystallized region that acts as a sealing member is thin, leading to the possibility of leakage. When the width is large, the resulting sealing region is thick, but the occupation area is large, which is not practical. Additionally, the thickness (height) of the convex bump part is not particularly limited and is determined according to the distance between substrates. The thickness is preferably 0.1 to 2.0 times the width (diameter) of the convex bump part. The cross-sectional shape of the convex bump part is not particularly limited and may be circular, rectangular, or the like.

The penetrating part and the convex bump part of the through electrode according to the present invention are each formed of a sintered body of a metal powder. This sintered body, whose formation process will be described in detail later, is prepared by sintering a metal powder of at least one metal selected from gold, silver, palladium, and platinum having a purity of 99.9 wt% or more and an average particle size of 0.005 µm to 1.0 µm. The reason why a high-purity metal is required as a condition for the metal powder for forming a sintered body is as follows: when the purity is low, the hardness of the powder increases, and, as a result, after formation into a sintered body, deformation/recrystallization is less likely to proceed, whereby the sealing effect may not be exerted. Additionally, as described below, for the formation of a sintered body, a metal paste containing a metal powder and a solvent is applied, and glass frit is not contained therein. Accordingly, the formed through electrode (penetrating part and convex bump part) contains the same high-purity metal as the powder. Specifically, the through electrode contains a metal having a purity of 99.9 wt% or more.

The through electrode according to the present invention includes, on a surface of the convex bump that comes in contact with the substrate, a frame-shaped metal film formed around the junction between the convex bump and the penetrating part. This metal film is formed to improve the adhesion between the convex bump and the substrate during the joining of the multilayer substrate, and also to apply uniform pressurization to the sintered body to induce suitable recrystallization.

The metal film on the convex bump contains gold, silver, palladium, or platinum having a purity of 99.9 wt% or more. The purpose thereof is to develop high-level adhesion by thermal diffusion with the metal powder. The reason why the purity is specified to be 99.9 wt% or more is that when the purity is lower, impurities in the metal film may be diffused as an oxide film over the metal film surface during heating, and joining may also be inhibited. More preferably, the metal film contains the same metal material as the metal of the metal powder forming the through electrode.

The thickness of the metal film is preferably 0.005 to 2.0 µm. For ensuring adhesion to the convex bump, the metal film preferably contains a metal in the form of a bulk body, and is preferably formed by plating (electrolytic plating, electroless plating), sputtering, deposition, a CVD method, or the like. The metal film may contain only one layer, but may also have a multilayer structure. For example, it is possible that a platinum film is formed on the substrate side and a gold layer is formed thereon on the convex bump side. In the case of a multilayer structure, a metal film containing the same material as the metal of the metal powder forming the through electrode is preferably formed on the convex bump side.

Additionally, the metal film may be directly formed on the substrate, but may also be formed through a underlying film. A underlying film is formed to improve the adhesion between the metal film and the substrate. As a underlying film, a film containing titanium, chromium, tungsten, a titanium-tungsten alloy, or nickel is preferable. The underlying film is also preferably formed by plating, sputtering, deposition, a CVD method, or the like, and also preferably has a thickness of 0.005 to 2.0 µm.

As a method for producing the through electrode according to the present invention described above, on a substrate having a through hole, first, a metal film is formed around the through hole, and then the through hole is filled with a metal paste containing a metal powder, followed by sintering; the through electrode is thus formed.

The metal film is preferably formed by a plating method, sputtering, deposition, a CVD method, or the like as described above. This is because the film thickness can be adjusted, and also it is easy to control the film formation position.

The metal paste for forming a through electrode basically contains: one or more kind of metal powder selected from gold, silver, palladium, and platinum having a purity of 99.9 wt% or more and an average particle size of 0.005 µm to 1.0 µm; and an organic solvent. As described above, the purity of the metal powder is specified to be 99.9% or more considering deformability and recrystallization after formation into a sintered body, and also considering the ensuring of electrical conductivity. Additionally, the reason why the average particle size of the metal powder is specified to be 0.005 µm to 1.0 µm is that when the metal powder has a particle size of more than 1.0 µm, and when a fine through hole is filled with the powder, large spaces are created, eventually making it impossible to ensure the necessary electrical conductivity, while the particle size is less than 0.005 µm such a powder is likely to aggregate in the metal paste, making it difficult to fill a through hole.

As organic solvents for use in the metal paste, ester alcohols, terpineol, pine oil, butylcarbitol acetate, butylcarbitol, carbitol, and perchlor are preferable. These solvents are less aggressive toward a resist and also can volatilize at relatively low temperatures (less than 50°C), facilitating drying after the application of the metal paste. In particular, perchlor allows for drying at room temperature and thus is particularly preferable.

For the blending ratio between the metal powder and the organic solvent in the metal paste to be applied, the metal powder is preferably 80 to 99 wt%, while the organic solvent is 1 to 20 wt%. The purpose of blending in such a ratio is to prevent the aggregation of the metal powder and also make it possible to supply the metal powder enough to form an electrode.

The metal paste used in the present invention may also contain an additive. This additive may be at least one kind selected from acrylic resins, cellulose resins, and alkyd resins. Examples of acrylic resins include methyl methacrylate polymer, examples of cellulose resins include ethyl cellulose, and examples of alkyd resins include phthalic anhydride resin. These additives have a suppressing effect on the aggregation of the metal powder in the metal paste and homogenize the metal paste. The amount of additive added is preferably 2 wt% or less relative to the metal paste. While maintaining the stable aggregation-suppressing effect, the metal powder content can be made within a range sufficient for filling the through hole.

However, unlike common metal pastes widely used for the formation of a wiring pattern on a substrate surface, and the like, the metal paste used in the present invention does not contain glass frit. The purpose of not mixing glass frit into the metal paste is to form a dense through electrode and also not allow impurities, which may inhibit recrystallization, to remain in the electrode. Components forming the metal paste other than the metal powder, such as the organic solvent, disappear in the drying or sintering step after filling, and thus do not serve as inhibiting factors like glass frit.

For filling the through hole of the substrate with the metal paste, a suitable amount of metal paste is supplied onto the substrate. At this time, a spin coating method, a screen printing method, an ink-jet method, a method in which the paste is dripped and then spread with a spatula, or the like can be applied. However, to form a preferred through electrode, an adequate amount of metal paste is preferably supplied, and then mechanical vibration at a predetermined frequency is applied to the metal paste. The metal paste applied in the present invention merely has a metal powder dispersed in an organic solvent and thus has poor fluidity, and, therefore, uniform migration is difficult. It is preferable to apply mechanical vibration to fill the through hole with the metal paste leaving no space.

The frequency of the mechanical vibration applied to the metal paste should be 60 Hz to 100 kHz. The poor fluidity of the metal paste can be cancelled by vibration within this range. More preferably, the frequency is 100 Hz to 30 kHz. The purpose thereof is to spread the paste all over the substrate.

As a specific technique for applying the metal paste to the substrate, while or after supplying the metal paste to the substrate, a blade (spatula) vibrated at the frequency is preferably brought into contact with the metal paste to spread the paste all over the substrate. When mechanical vibration is directly applied to the metal paste, the metal powder in the metal paste is vibrated, whereby the fluidity improves. For this purpose, mechanical vibration is preferably applied only to the metal paste. Additionally, also for the purpose of maintaining the frequency within the range, the blade is preferably maintained to avoid contact with the substrate. The distance (gap) between the blade edge and the substrate is preferably 50 to 200 µm. The substrate herein includes one having a resist layer, a conducting layer, or the like formed on the substrate surface. Therefore, the gap between the blade edge and the substrate means the distance from the outermost surface of the substrate.

Further, in a more preferred aspect for the metal paste to completely enter the through hole, the through hole is depressurized to suck the metal paste. As a method for depressurizing the through hole, the back side of the substrate (opposite side to the metal paste application side) is preferably depressurized preferably to -10 to -90 kPa. As a result of the application of mechanical vibration to the metal paste and the depressurization of the through hole, the through hole is filled with the metal paste to form a penetrating part, and a convex bump is also formed at the same time.

After filling the substrate with the metal paste, it is preferable to dry the metal paste. This is because when filling is immediately followed by sintering, gas generation due to the volatilization of the organic solvent occurs so rapidly that voids are formed, affecting the shape of the sintered body. Additionally, when drying is once performed, the metal powder in the through hole can be temporarily fixed, whereby handleability can be secured for the resist removal described below, for example. In this drying step, the drying temperature is preferably 100°C or less, and room temperature is also viable.

The heating temperature for sintering the metal paste is preferably 150 to 300°C. This is because when it is less than 150°C, the metal powder in the through hole cannot be sufficiently sintered, while when it is more than 300°C, sintering excessively proceeds, whereby necking proceeds in the metal powder, and, as a result, the hardness increases too much or the volume decreases. Additionally, when the sintering temperature is too high, the substrate or the conducting layer thereon may be affected.

As a result of the application and sintering of the metal paste described above, the metal powder is sintered and solidified, whereby a through electrode is formed. The through electrode formed under the conditions does not allow for a space with the wall of the through hole, and has also been moderately densified to serve as an excellent electrical conductor.

The substrate applied in the present invention is not particularly limited. A diameter of the through hole is adaptable to a fine metal powder, and micropores of about 5 to 50 µm can also be filled. Additionally, a substrate having preliminarily formed thereon masking can also be applied, such as a resist or a photosensitive film. In this case, after applying a metal paste (filling), it is preferable to remove the masking film after the metal paste is dried. As described above, the drying temperature may be a relatively low temperature, and the masking film is not damaged at such a temperature. The metal powder after drying is in a temporarily fixed state, and the metal powder in the through hole does not take off even the masking is removed at this time. Thus, a through electrode can be efficiently formed by the performance of drying, masking removal, and sintering in this order.

By use of a substrate provided with the through electrode described above, while sealing a semiconductor device on the substrate and also achieving efficient wiring, a laminated substrate having a multilayer structure can be produced. As the production process for this laminated substrate, a substrate provided with the through electrode according to the present invention and another substrate to be applied are stacked and pressurized in a heated atmosphere, whereby the through electrode is densified and joined, giving a multilayer substrate. As the sealing/joining conditions at this time, the heating temperature should be 80 to 300°C, and the pressurizing condition should be 30 to 300 MPa. Preferably, the heating temperature is 150 to 250°C, and the pressurizing condition is 60 to 250 MPa. Additionally, the jointing treatment time is preferably 0.5 to 3 hours. In the production of a multilayer substrate, it is preferable to form the same metal film (electrode) as the metal film in the present invention at the convex-bump-joining position of the applied other substrate. The reason is that such a formation will ensure the adhesion of the convex bump at such a position and ensure the sealing capability.

### Advantageous Effects of the Invention

As described above, the through electrode according to the present invention has a sealing effect in addition to the function as an electrode. Accordingly, the through electrode is suitable for application to elements that require hermetic sealing during mounting, such as MEMS elements. According to the present invention, the substrate structure can be multilayered, and also the element trace length can be reduced. As a result, the element can effectively exert its electrical characteristics.

### Brief Description of the Drawings

Fig. 1 illustrates the densification of a convex bump.
Fig. 2 illustrates one aspect of the through electrode according to the present invention.
Fig. 3 illustrates the through electrode production process in this embodiment.
Fig. 4 illustrates the multilayer substrate mounting process applying the through electrode according to this embodiment.
Fig. 5 shows photographs of the structure of the through electrode No. 7 of this embodiment.
Fig. 6 shows an example of a conventional multilayer substrate mounting process using a through electrode and considering hermetic sealing.

### Description of Embodiments

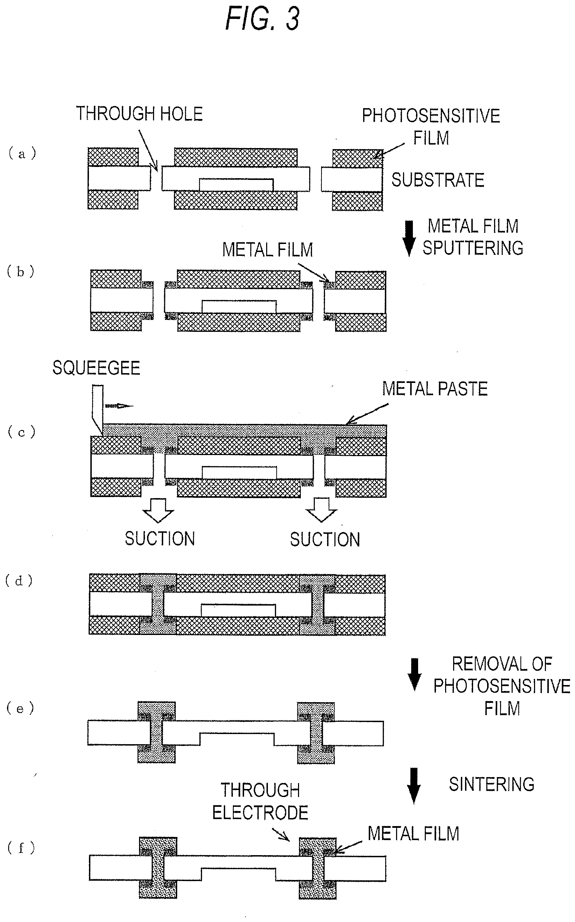

Hereinafter, a preferred embodiment of the present invention will be described. In this embodiment, a through electrode was produced on a silicon substrate while varying the materials for a metal powder and a metal film, and the sealing performance was examined. The through electrode production process in this embodiment is illustrated in Fig. 3.

First, a metal paste to serve as a raw material of a sintered body for forming an electrode was prepared. As the metal paste, one prepared by mixing a metal powder produced by a wet reduction method with perchlor, an organic solvent, was used (the amount of gold powder mixed: 90 wt%).

Additionally, on a substrate (material: silicon, dimension: 30 mm × 20 mm, 250 µm in thickness) with a 20-µm-diameter through hole formed, a photosensitive film (20 µm) was attached to each side, and then the circumference of the through hole (60 µm in diameter) was exposed to light (40 mJ/cm², using a direct exposure machine at a wavelength of 405 nm), and the film is developed to form an opening. At this time, the level difference between the photosensitive film and the substrate corresponds to the height of a convex bump on the through electrode, and the dimension of the resulting convex bump is 20 µm in height and 60 µm in diameter. On this resist-treated substrate, Ti (0.05 µm) was formed as an underlying film by a spattering method, and then a metal film was formed (Fig. 3(b)).

Next, the metal paste was dripped onto the substrate and spread all over the substrate with a silicon blade (blade width: 30 mm) vibrating at a frequency of 300 Hz (Fig. 3(c), (d)). Additionally, this metal paste application step is performed while creating a reduced pressure atmosphere on the back side of the substrate (-10 kPa to -90 kPa) such that the paste on the applied surface of the substrate is sucked into the through hole. In the state of Fig. 3(d), the substrate was entirely dried at 100°C for 1 hour, and then the photosensitive film was removed, and the shape of a through electrode is formed, with the through hole being filled with the metal powder (Fig. 3(e)).

Subsequently, heating was performed at 230°C for 2 hours to sinter the metal powder, and a through electrode was produced (Fig. 3(f)).

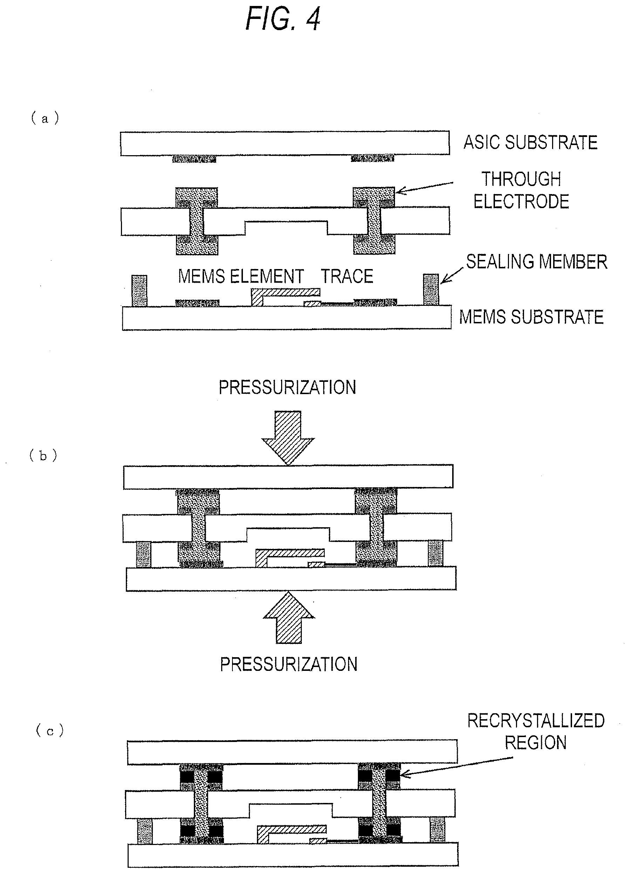

Fig. 4 shows a laminated substrate mounting process using a substrate provided with the through electrode produced as above. In this example, an ASIC (Application Specific Integrated Circuit) substrate is laminated with an MEMS substrate that has previously undergone the formation of a wiring pattern, the mounting of an element, and the setting of a sealing member. The through electrode is set on the MEMS substrate.

As shown in Fig. 4(a), after the substrates are stacked, a load is applied from the upper and lower sides in a heated atmosphere to compress the sintered body forming the through electrode (Fig. 4 (b)). As a result of pressurization, the portion of the convex bump sintered body around the through hole is densified, and the adhesion between the sintered body and the metal film is improved simultaneously (Fig. 4 (c)). As a result, a ring-shaped recrystallized region is formed in the convex bump sintered body of the through electrode. Accordingly, leakage from the MEMS substrate side and the ASIC substrate side are suppressed.

In this example, at the outer periphery of the MEMS substrate, a sintered body containing the same metal powder as the metal powder forming the through electrode is provided as a sealing member (Fig. 4 (a)). As a result of the application of a sealing member formed of this sintered body, simultaneously with the compression of the through electrode, the hermetic sealing of the MEMS element on the MEMS substrate can be also completed.

Based on the above process, the material for forming a through electrode was varied to produce through electrodes, and they were each mounted on a laminated substrate (mounting process conditions: 200 MPa, 250°C, 30 minutes). The resulting substrates (the number of samples n = 3) were subjected to a helium leak test (bell jar method) to evaluate the sealing performance. In this evaluation, a helium leak rate of 10⁻⁹ Pa·m³/s or less was graded as "Pass". The evaluation results are shown in Table 1.

**[Table 1]**

| No. | Metal powder | | | Convex bump/penetrating part^{*1} | Metal film^{*2} | | Results of sealing test | |
|---|---|---|---|---|---|---|---|---|
| | Kind | Purity | Average particle size | | Kind | Thickness^{*3} | Leak rate (Pa·m³/s) | Evaluation |
| 1 | Au | 99.9% | 0.005 µm | 1.7 | Au | 0.005 µm | 10⁻⁹ to 10⁻¹¹ | Pass |
| 2 | | | 0.3 µm | 3.0 | | 0.2 m | 10⁻¹ to 10⁻¹³ | Pass |
| 3 | | | 1.0 µm | 10 | | 2.0 µm | 10⁻¹¹ to 10⁻¹³ | Pass |
| 4 | | 99.9% | 0.005 µm | 1.7 | | 0.003 m | 10⁻⁵ to 10⁻⁸ | Failure |
| 5 | | 99.0% | 0.3 µm | 3.0 | | 0.2 m | 10⁻⁵ to 10⁻⁸ | Failure |
| 6 | | 99.9% | 1.2 µm | 1.3 | | 2.0 µm | 10⁻⁵ to 10⁻⁸ | Failure |
| 7 | | 99.9% | 0.3 µm | 3.0 | - | - | 10⁻⁵ to 10⁻⁸ | Failure |
| 8 | Ag | 99.9% | 0.005 µm | 1.7 | Ag | 0.005 µm | 10⁻⁹ to 10⁻¹¹ | Pass |
| 9 | | | 0.3 µm | 3.0 | | 0.2 m | 10⁻¹¹ to 10⁻¹³ | Pass |
| 10 | | | 1.0 µm | 10 | | 2.0 µm | 10⁻¹¹ to 10⁻¹³ | Pass |
| 11 | Pd | 99.9% | 0.005 µm | 1.7 | Pd | 0.005 µm | 10⁻⁹ to 10⁻¹¹ | Pass |
| 12 | | | 0.3 µm | 3.0 | | 0.2 m | 10⁻¹¹ to 10⁻¹³ | Pass |
| 13 | | | 1.0 µm | 10 | | 2.0 µm | 10⁻¹¹ to 10⁻¹³ | Pass |
| 14 | Pt | 99.9% | 0.005 µm | 1.7 | Pt | 0.005 µm | 10⁻⁹ to 10⁻¹¹ | Pass |
| 15 | | | 0.3 µm | 3.0 | | 0.2 m | 10⁻¹¹ to 10⁻¹³ | Pass |
| 16 | | | 1.0 µm | 10 | | 2.0 µm | 10⁻¹¹ to 10⁻¹³ | Pass |

| | | | | | | | | |
|---|---|---|---|---|---|---|---|---|
| *1: Convex bump diameter/penetrating part diameter *2 Each having a Ti film (0.05 µm) formed as a underlying film on the substrate side. | | | | | | | | |

From Table 1, it can be seen that a through electrode in which the metal powder and the metal film are suitably constituted exerts excellent sealing performance. When the purity of the metal powder is low (No. 5) or when its particle size is too large (No. 6), the hermeticity decreases. Additionally, for the metal film, when it is too thin (No. 4), the hermeticity decreases. Further, also when only an underlying film (Ti) is formed without setting a metal film (No. 7), the hermeticity is low. It appears that these decreases in hermeticity are attributable to the formation of coarse pores due to the insufficient adhesion of the convex bump to the substrate. Fig. 5 shows the results of the observation of the structure of the through electrode No. 7 having no metal film applied. Although the central outer periphery of the convex bump has a dense structure, coarse pore are formed at the interface of the substrate.

### Industrial Applicability

The present invention is useful as a through electrode for forming a multilayer substrate to be installed on a circuit board for various electronic and electrical devices. The present invention responds to the progress of the development of smaller-size, higher-integration circuit boards, which will be accelerated in the future.

## Claims

1. A through electrode for being mounted on a substrate having a through hole, comprising:
a penetrating part passing through the through hole;
a convex bump part formed on at least one end of the penetrating part and wider than the penetrating part; and
a metal film having at least one layer and formed on a surface of the convex bump part coming in contact with the substrate, wherein
the penetrating part and the convex bump part are formed of a sintered body prepared by sintering one or more kind of metal powder selected from gold, silver, palladium, and platinum having a purity of 99.9 wt% or more and an average particle size of 0.005 µm to 1.0 µm, and
the metal film contains gold, silver, palladium, or platinum having a purity of 99.9 wt% or more.

2. The through electrode according to claim 1, wherein the metal film has a thickness of 0.005 to 2.0 µm.

3. The through electrode according to claim 1 or 2, wherein the convex bump part has a diameter 1.5 to 10 times that of the penetrating part.

4. The through electrode according to any of claims 1 to 3, comprising an underlying film containing titanium, chromium, tungsten, a titanium-tungsten alloy, or nickel between the metal film and the substrate.

5. A method for producing a multilayer substrate by joining a substrate provided with the through electrode defined in any of claims 1 to 4 to another substrate, comprising the steps of:
stacking the other substrate and the substrate, and pressurizing the stack at 30 to 300 MPa from one or both directions while heating to 80 to 300°C, to densify the through electrode.

## Patentansprüche

1. Durchkontaktierungselektrode zum Anordnen auf einem Substrat mit einem Durchgangsloch, umfassend:
ein Durchdringungsteil , das durch das Durchgangsloch verläuft;
ein konvexes erhobenes Teil, ausgebildet an mindestens einem Ende des Durchdringungsteils, und welches breiter als das Durchdringungsteil ausgebildet ist; und
einen Metallfilm aus mindestens einer Schicht und der auf einer Oberfläche des konvexen erhobenen Teils ausgebildet ist und mit dem Substrat in Kontakt kommt,
worin das Durchdringungsteil und der konvexe erhobene Teil aus einem gesinterten Körper gebildet sind, hergestellt durch Sintern einer oder mehrerer Arten Metallpulver, ausgewählt aus Gold, Silber, Palladium und Platin mit einer Reinheit von 99,9 Gew .-% oder mehr und einer durchschnittlichen Teilchengröße von 0,005 µm bis 1,0 µm,
und worin der Metallfilm Gold, Silber, Palladium oder Platin mit einer Reinheit von 99,9 Gew .-% oder mehr enthält.

2. Durchgangselektrode nach Anspruch 1, worin der Metallfilm eine Dicke von 0,005 bis 2,0 µm aufweist.

3. Durchgangselektrode nach Anspruch 1 oder 2, wobei der konvexe erhobene Teil einen Durchmesser aufweist, der das 1,5- bis 10-fache des Durchmessers des Durchdringungsteils ist.

4. Durchgangselektrode nach einem der Ansprüche 1 bis 3, umfassend einen darunter liegenden Film, der Titan, Chrom, Wolfram, eine Titan-WolframLegierung oder Nickel zwischen dem Metallfilm und dem Substrat enthält.

5. Verfahren zum Herstellen eines Mehrschichtsubstrats durch Verbinden eines Substrats, das mit der Durchgangselektrode nach einem der Ansprüche 1 bis 4 ausgestattet ist, mit einem weiteren Substrat, umfassend die Schritte: Stapeln des weiteren Substrats und des Substrats und Unterdrucksetzen des Stapels bei 30 bis 300 MPa aus einer oder beiden Richtungen unter Erwärmen auf 80 bis 300 °C, um die Durchgangselektrode zu verdichten.

## Revendications

1. Électrode traversante destinée à être montée sur un substrat ayant un trou traversant, comprenant :
une partie pénétrante passant à travers le trou traversant ;
une partie bombée convexe formée sur au moins une extrémité de la partie pénétrante et étant plus large que la partie pénétrante ; et
un film métallique ayant au moins une couche et formé sur une surface de la partie bombée convexe venant en contact avec le substrat, où
la partie pénétrante et la partie bombée convexe sont formées d'un corps fritté préparé par frittage d'un ou de plusieurs type(s) de poudre métallique choisi(s) parmi l'or, l'argent, le palladium et le platine ayant une pureté supérieure ou égale à 99,9% en poids et une taille moyenne de particules allant de 0,005 µm à 1,0 µm, et
le film métallique contient de l'or, de l'argent, du palladium ou du platine ayant une pureté supérieure ou égale à 99,9% en poids.

2. Électrode traversante selon la revendication 1, dans laquelle le film métallique a une épaisseur allant de 0,005 à 2,0 µm.

3. Électrode traversante selon la revendication 1 ou 2, dans laquelle la partie bombée convexe a un diamètre allant de 1,5 à 10 fois celui de la partie pénétrante.

4. Électrode traversante selon l'une des revendications 1 à 3, comprenant un film sous-jacent contenant du titane, du chrome, du tungstène, un alliage de titane-tungstène ou du nickel entre le film métallique et le substrat.

5. Procédé de production d'un substrat multicouche en assemblant un substrat pourvu de l'électrode traversante définie dans l'une des revendications 1 à 4 à un autre substrat, comprenant les étapes consistant :
à empiler l'autre substrat et le substrat, et à mettre l'empilement sous pression allant de 30 à 300 MPa à partir d'une ou des deux direction(s) lors du chauffage à une température allant de 80 à 300°C, pour densifier l'électrode traversante.
